Europäisches Patentamt

European Patent Office

Office européen des brevets

(19)

(11) Veröffentlichungsnummer: **0 214 511 B1**

(12) **EUROPÄISCHE PATENTSCHRIFT**

(45) Veröffentlichungstag der Patentschrift: **31.10.90**

(51) Int. Cl.⁵: **G11C 11/411**

(21) Anmeldenummer: **86111439.5**

(22) Anmeldetag: **19.08.86**

(54) **Bipolare Speicherzelle mit externer Kapazität.**

(30) Priorität: **21.08.85 DE 3529898**

(43) Veröffentlichungstag der Anmeldung:
**18.03.87 Patentblatt 87/12**

(45) Bekanntmachung des Hinweises auf die Patenterteilung:
**31.10.90 Patentblatt 90/44**

(84) Benannte Vertragsstaaten:
**AT DE FR GB IT NL**

(56) Entgegenhaltungen:
**DE-A- 2 129 166**
**DE-A- 3 023 851**
**US-A- 4 355 374**

**ELECTRONIC ENGINEERING, Band 55, Nr. 675,**
**März 1983, Seite 10, London, GB: "Linear silicon gate**
**CMOS - the TI way"**

(73) Patentinhaber: **Siemens Aktiengesellschaft,**
**Wittelsbacherplatz 2, D-8000 München 2(DE)**

(72) Erfinder: **Werner, Wolfgang, Dr.-Ing.,**
**Säbenerstrasse 256, D-8000 München 90(DE)**

## Beschreibung

Die Erfindung betrifft eine bipolare Speicherzelle nach dem Oberbegriff des Patentanspruchs 1.

Eine derartige Speicherzelle für einen statischen bipolaren Speicher mit wahlfreiem Zugriff ist aus einem Aufsatz von Masaaki Inadachi et. al.: A 6ns 4Kb Bipolar RAM using Switched Load Resistor Memory Cell, IEEE-ISSCC 1979, Seite 108 folgende bekannt. Das Prinzip einer derartigen Speicherzelle beruht darauf, daß immer einer der Zwei-Emitter-Transistoren leitet und der andere gesperrt ist. Dazu sind die Kollektoren der Transistoren kreuzweise auf die Basen zurückgekoppelt und über jeweils die Parallelschaltung eines hochohmigen Lastwiderstands und einer Schottky-Diode in Serie zu einem niederohmigen Lastwiderstand mit einer oberen Wortleitung verbunden, während je ein Emitter an eine gemeinsame untere Wortleitung und je einer an jeweils eine Bitleitung angeschlossen ist.

Ein bipolarer Speicher enthält eine Vielzahl derartiger, in Matrixform angeordneter Speicherzellen. Die Zeilenanwahl erfolgt über die obere Wortleitung, die potentialmäßig angehoben oder abgesenkt wird. Das Potential der unteren Wortleitung folgt der oberen Wortleitung. Die Spaltenanwahl erfolgt durch die beiden Bitleitungen und die Feststellung, welcher der Transistoren leitend ist und welcher nicht.

Im Stand by-Betrieb ist der hochohmige Lastwiderstand des leitenden Transistors wirksam, da die obere Wortleitung und die Bitleitungen nicht angewählt sind. Bei der Anwahl einer Zelle werden einerseits die obere Wortleitung potentialmäßig angehoben und andererseits die Bitleitungen an eine Stromquelle geschaltet. Dadurch fließt ein Strom durch die Schottky-Dioden und den niederohmigen Lastwiderstand, so daß der resultierende Gesamtlastwiderstand des leitenden Transistors niederohmig wird. Der Strom bei der Anwahl der Speicherzelle liegt etwa 2 bis 3 Größenordnungen oberhalb des Stand by-Stroms.

Beim Speichern der Information verläuft der Vorgang umgekehrt, wobei ein Transistor schnell in den leitfähigen Zustand, der andere relativ langsam in den Sperrzustand gelangt. Der niederohmige Lastwiderstand sorgt dabei in Verbindung mit der Speicherkapazität für den erforderlichen Speicherhub von etwa 400 bis 500 mV.

Die bei der Informationsspeicherung in Halbleiterspeichern grundsätzlich als Speicher elektrischer Ladung dienenden Kapazitäten werden bei bipolaren Speichern nach dem Stand der Technik (vergl. z.B. DE-A 3 023 851) durch die Basis-Kollektor- und die SchottkydiodenKapazität gebildet, deren Wert etwa 400 fF beträgt. Dieser relativ große Kapazität bedingt große spezifische Kapazitäten und große Flächen für die Schottkydiode und die Basis der Transistoren. Nachteilig ist dabei, daß die Kapazität des pn-Übergangs spannungsabhängig ist und daß die aktive Fläche der Bauelemente größer als von den Designrules und Emitterflächen her erforderlich ist, woraus eine große Kollektor-Substrat-Kapazität resultiert. Weiterhin vergrößert eine große spezifische Basis-Kollektor-Kapazität die typischen Zeitkonstanten, die sich bei Logikanwendungen nachteilig auswirken. In der genannten DE-A 3 023 851 sind die Basis-Kollektor-Kapazitäten durch innerhalb des aktiven Bereichs der Speicherstellen liegende pn-Übergänge realisiert.

Die Kollektor-Substrat-Kapazität einer bipolaren Speicherzelle soll andererseits aus Gründen der Störsicherheit der Zelle möglichst klein sein, da bei einem Umschreibvorgang zunächst die Kollektor-Substrat-Kapazität umgeladen werden muß und somit der Aufladung der Speicherkapazität entgegen wirkt. Erfahrungsgemäß soll dabei das Verhältnis von wirksamer Speicherkapazität zur parasitären Kollektor-Substrat-Kapazität größer 5 sein.

Der Erfindung liegt die Aufgabe zugrunde, Logikgeschwindigkeit und Störsicherheit einer bipolaren Speicherzelle zu verbessern und die Möglichkeit zu bieten, die Zellenbauelemente separat zu optimieren und zu dimensionieren.

Diese Aufgabe wird bei einer bipolaren Speicherzelle der eingangs genannten Art erfindungsgemäß durch die Merkmale des kennzeichnenden Teils des Patentanspruchs 1 gelöst.

Weitere Ausgestaltungen des Erfindungsgedankens sind in Unteransprüchen gekennzeichnet.

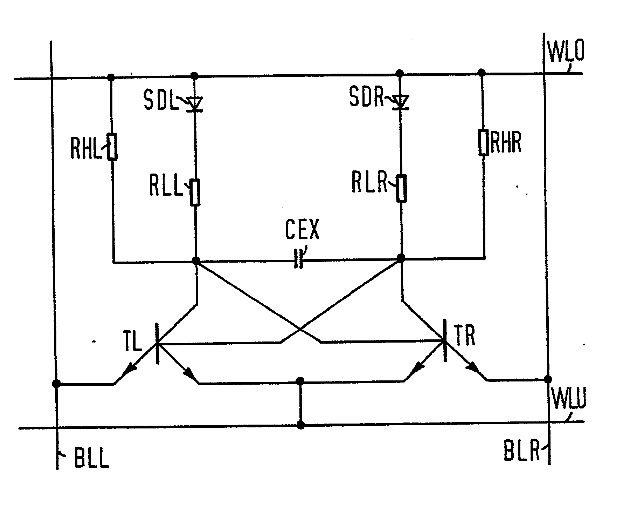

Die Erfindung wird im folgenden anhand des in der Figur der Zeichnung dargestellten Schaltbildes näher erläutert.

Gemäß der Figur gehören zur Bitleitung BLL der Transistor TL mit seinem hochohmigen Kollektorwiderstand RHL parallel zur Serienschaltung aus der Schottky-Diode SDL und des niederohmigen Widerstandes RLL. Zur rechten Bitleitung BLR gehören die entsprechenden Elemente TR, RHR, SDR und RLR. Der gemeinsame Verbindungspunkt der Schottky-Dioden SDL und SDR und der Widerstände RHL und RHR ist mit der oberen Wortleitung WLO und jeweils ein Emitter der Transistoren TL und TR mit der unteren Wortleitung WLU verbunden. Der zweite Emitter von TL ist mit der Bitleitung BLL und der zweite Emitter von TR mit der Bitleitung BLR verbunden. Der Kollektor des Transistors TL ist auf die Basis des Transistors TR und der Kollektor des Transistors TR auf die Basis des Transistors TL zurückgeführt.

Die Erfindung sieht vor, für die erforderliche Speicherkapazität im Wesentlichen eine außerhalb des aktiven Bereichs der Transistoren liegende Kapazität zu verwenden, die zwischen die Kollektoren der Transistoren TL und TR geschaltet wird und somit zwischen den Kollektor- bzw. Basisanschlüssen der bei den Transistoren liegt.

Die externe Kapazität CEX kann auf verschiedene Art realisiert werden, z.B. als Stapel-Kapazität (stacked capacitor) oder als Graben-Kapazität (trench capacitor). Bei der Ausführung als Stapelkapazität wird CEX durch zwei hochdotierte Polysiliciumschichten mit einem dazwischenliegenden Dielektrikum aus Siliciumdioxid oder Siliciumnitrid gebildet, dessen Dicke weniger als 30 nm, vorzugsweise 10 bis 20 nm beträgt. Als Dielektrikum kann auch eine Zwei- oder Dreifachschicht aus Siliciumoxid und Siliciumnitrid bzw. Siliciumoxid, Siliciumnitrid und Siliciumoxid verwendet werden. Die Stapelkapazität kann sowohl über den aktiven Bauelementen als auch zwischen den aktiven Bauelementen angeordnet sein. Eine zwischen den aktiven Bauelementen liegende externe Kapazität kann auf einem Isolationsoxid aufgebracht sein, dessen Dicke über 1 µm, vorzugsweise etwa 1,3 µm beträgt.

Es liegt im Rahmen der Erfindung, die übrigen Bauelemente der bipolaren Speicherzelle hinsichtlich ihrer Eigenschaften separat zu optimieren. So kann beispielsweise die Transistorfläche verkleinert werden, woraus sich eine kleinere Kollektor-Substrat-Kapazität und eine reduzierte Empfindlichkeit gegenüber Alpha-Partikeln ergibt. Die Transistoren können dabei unabhängig von den Kollektor-Basis- und Schottkydioden-Kapazitäten sowie der hoch- und niederohmigen Lastwiderstände optimiert werden. Erfindungsgemäß werden deshalb auch die hoch- und niederohmigen Lastwiderstände so dimensioniert und optimiert, daß ihre parasitären Kapazitäten vernachläßigbar klein werden.

Insgesamt kann deshalb das Verhältnis von wirksamer Speicherkapazität als der Summe aus der externen Kapazität CEX, der Kollektor-Basis- und der Schottkydioden-Kapazität zu Kollektor-Substrat-Kapazität in großen Bereichen verändert werden. Damit ergibt sich die Möglichkeit, eine Optimum an Störsicherheit und Geschwindigkeit zu erzielen. Gleichzeitig wird eine höhere Ausbeute und eine geringere Empfindlichkeit gegenüber Alpha-Partikeln möglich.

Es ist weiterhin vorgesehen, die hochohmigen und oder niederohmigen Lastwiderstände als externe Widerstände zu gestalten. Durch diese Maßnahme läßt sich die Zellenfläche weiter verringern, da nach dem Stand der Technik zum Beispiel der hochohmige Widerstand als ionenimplantierter Widerstand und der niederohmige Lastwiderstand als Buried-Layer-Widerstand ausgebildet ist.

Eine geringere Fläche der bipolaren Speicherzelle ermöglicht entweder eine höhere Packungsdichte bei gleicher Chipgröße oder aber einen größeren Abstand zwischen den einzelnen Transistoren. Da die Transistoren üblicherweise im Halbleitersubstrat angeordnete Buried-Layer-Zonen besitzen und durch Channel-Stopper voneinander getrennt sind, resultieren aus größeren Abständen zwischen den Transistoren kleinere Kollektor-Substrat-Kapazitäten im Sinne einer Erhöhung der Störsicherheit.

Eine auch topologisch günstige Ausgestaltung ergibt sich, wenn die jeweils einer Bitleitung zugeordneten Elemente geometrisch in zwei Gruppen, einerseits TL, SDL, RHL und RLL und andererseits TR, SDR, RHR und RLR, angeordnet sind, zwischen denen die externe Kapazität CEX liegt.

## Patentansprüche

1. Integrierte bipolare Speicherzelle mit wahlfreiem Zugriff mit zwei Zwei-Emitter-Transistoren (TL, TR) deren Kollektoren kreuzweise auf die Basen rückgekoppelt und über jeweils die Parallelschaltung eines hochohmigen Lastwiderstandes (RHL, RHR) mit einer Serienschaltung aus einer Schottkydiode (SDL, SDR) und einem niederohmigen Lastwiderstand (RLL, RLR) mit einer oberen Wortleitung (WLO) verbunden sind, von deren Emittern je einer an eine untere Wortleitung (WLU) und je einer an jeweils eine Bitleitung (BLL, BLR) angeschlossen ist, **gekennzeichnet** durch eine zwischen den Kollektoren außerhalb aktiver Bereiche (TL, TR, SDL, SDR) liegende externe Kapazität (CEX).

2. Bipolare Speicherzelle nach Anspruch 1, **dadurch gekennzeichnet**, daß die externe Kapazität (CEX) groß gegenüber parasitäten Substratkapazitäten ausgebildet ist.

3. Bipolare Speicherzelle nach Anspruch 1 oder 2, **dadurch gekennzeichnet**, daß die externe Kapazität (CEX) aus zwei hochdotierten Polysilicium-Schichten mit einem dazwischen liegenden Dielektrikum aus einer Schicht aus Siliciumoxid oder Siliciumnitrid, einer Zweifachschicht aus Siliciumoxid und Siliciumnitrid oder einer Dreifachschicht aus Siliciumoxid, Siliciumnitrid und Siliciumoxid gebildet wird.

4. Bipolare Speicherzelle nach Anspruch 1 bis 3, **dadurch gekennzeichnet**, daß die Dicke des Dielektrikums weniger als 30 nm beträgt.

5. Bipolare Speicherzelle nach Anspruch 1 bis 4, **dadurch gekennzeichnet**, daß die externe Kapazität (CEX) als Stapel-Kapazität ausgebildet ist.

6. Bipolare Speicherzelle nach Anspruch 1 bis 5, **dadurch gekennzeichnet**, daß die externe Kapazität (CEX) auf oder zwischen aktiven Bereichen (TL, TR, SDL, SDR) liegt.

7. Bipolare Speicherzelle nach Anspruch 1 bis 6, **dadurch gekennzeichnet**, daß die externe Kapazität (CEX) auf Isolationsoxid aufgebracht ist.

8. Bipolare Speicherzelle nach Anspruch 1 bis 7, **dadurch gekennzeichnet**, daß die Dicke des Isolationsoxids über 1 µm beträgt.

9. Bipolare Speicherzelle nach Anspruch 1 bis 4, **dadurch gekennzeichnet**, daß die exterene Kapazität als Graben-Kapazität ausgebildet ist.

10. Bipolare Speicherzelle nach Anspruch 1 bis 9, **gekennzeichnet** durch außerhalb der aktiven Bereiche (TL, TR, SDL, SDR) liegende externe hochohmige (RHL, RHR) und/oder niederohmige Lastwiderstände (RLL, RLR).

11. Bipolare Speicherzelle nach Anspruch 1 bis 10, **dadurch gekennzeichnet**, daß die jeweils einer Bitleitung (BLL; BLR) zugeordneten Elemente (TL, SDL, RHL, RLL; TR, SDR, RHR, RLR) geometrisch in zwei Gruppen angeordnet sind, zwischen denen die externe Kapazität (CEX) liegt.

## Claims

1. Integrated bipolar memory cell with random access, having two two-emitter transistors (TL, TR), the collectors of which are fed back crosswise to the bases, and are connected via in each case the parallel circuit of a high-resistance load resistor (RHL, RHR) with a series circuit composed of a Schottky diode (SDL, SDR) and a low-resistance load resistor (RLL, RLR) to an upper word line (WLO), of the emitters of which transistors, in each case one is connected to a lower word line (WLU) and one is connected to in each case one bit line (BLL, BLR), characterized by an external capacitance (CEX) lying between the collectors outside active regions (TL, TR, SDL, SDR).

2. Bipolar memory cell according to Claim 1, characterized in that the external capacitance (CEX) is designed to be large with respect to parasitic substrate capacitances.

3. Bipolar memory cell according to Claim 1 or 2, characterized in that the external capacitance (CEX) is formed from two highly doped polysilicon layers with a dielectric lying therebetween composed of a layer of silicon oxide or silicon nitride, a double layer of silicon oxide and silicon nitride or a triple layer of silicon oxide, silicon nitride and silicon oxide.

4. Bipolar memory cell according to Claim 1 to 3, characterized in that the thickness of the dielectric is less than 30 nm.

5. Bipolar memory cell according to Claim 1 to 4, characterized in that the external capacitance (CEX) is designed as a stacked capacitor.

6. Bipolar memory cell according to Claim 1 to 5, characterized in that the external capacitance (CEX) lies on or between active regions (TL, TR, SDL, SDR).

7. Bipolar memory cell according to Claim 1 to 6, characterized in that the external capacitance (CEX) is applied to insulating oxide.

8. Bipolar memory cell according to Claim 1 to 7, characterized in that the thickness of the insulating oxide is more than 1 $\mu$m.

9. Bipolar memory cell according to Claim 1 to 4, characterized in that the external capacitance is designed as a trench capacitor.

10. Bipolar memory cell according to Claim 1 to 9, characterized by external high-resistance (RHL, RHR) and/or low-resistance load resistors (RLL, RLR) lying outside the active regions (TL, TR, SDL, SDR).

11. Bipolar memory cell according to Claim 1 to 10, characterized in that the elements (TL, SDL, RHL, RLL; TR, SDR, RHR, RLR) associated in each case with a bit line (BLL, BLR) are disposed geometrically in two groups, between which the external capacitance (CEX) lies.

## Revendications

1. Cellule de mémoire bipolaire intégrée à accès direct, comportant deux transistors (TL, TR) à deux émetteurs, dont les émetteurs sont couplés par réaction aux bases selon un montage croisé et sont reliés à une ligne supérieure de transmission de mots (WLO) par l'intermédiaire respectivement du circuit parallèle formé d'une résistance de charge de forte valeur ohmique (RHL, RHR) et d'un circuit série formé d'une diode Schottky (SDL, SDR) et d'une résistance de charge de faible valeur ohmique (RLL, RLR), et dont les émetteurs sont reliés respectivement l'un à une ligne inférieure de transmission de mots (WLO) et l'autre respectivement à une ligne de transmission de bits (BLL, BLR), caractérisée par une capacité externe (CEX) branchée entre les collecteurs à l'extérieur de zones actives (TL, TR, SDL, SDR).

2. Cellule de mémoire bipolaire selon la revendication 1, caractérisée par le fait que la capacité externe (CEX) possède une valeur élevée par rapport à des capacités parasites du substrat.

3. Cellule de mémoire bipolaire suivant la revendication 1 ou 2, caractérisée par le fait que la capacité externe (CEX) est formée par deux couches en polysilicium fortement dopées, entre lesquelles est intercalé un diélectrique constitué par une couche formée d'oxyde de silicium ou de nitrure de silicium, une couche double formée d'oxyde de silicium ou de nitrure de silicium ou une couche triple formée d'oxyde de silicium, de nitrure de silicium et d'oxyde de silicium.

4. Cellule de mémoire bipolaire suivant les revendications 1 à 3, caractérisée par le fait que l'épaisseur du diélectrique est inférieure à 30 nm.

5. Cellule de mémoire bipolaire suivant les revendications 1 à 4, caractérisée par le fait que la capacité externe (CEX) est réalisée sous la forme d'une capacité empilée.

6. Cellule de mémoire bipolaire suivant l'une des revendications 1 à 5, caractérisée par le fait que la capacité externe (CEX) est située sur ou entre des zones actives (TL, TR, SDL, SDR).

7. Cellule de mémoire bipolaire suivant les revendications 1 à 6, caractérisée par le fait que la capacité externe (CEX) est déposée sur un oxyde isolant.

8. Cellule de mémoire bipolaire suivant l'une des revendications 1 à 7, caractérisée par le fait que l'épaisseur de l'oxyde isolant dépasse 1 $\mu$m.

9. Cellule de mémoire bipolaire suivant les revendications 1 à 4, caractérisée par le fait que la capacité externe est réalisée sous la forme d'une capacité enterrée.

10. Cellule de mémoire bipolaire suivant les revendications 1 à 9, caractérisée par des résistances de charge externes de forte valeur ohmique (RHL, RHR) et/ou de faible valeur ohmique (RLL, RLR), situées à l'extérieur des zones actives (TL, TR, SDL, SDR).

11. Cellule de mémoire bipolaire suivant les revendications 1 à 10, caractérisée par le fait que les éléments (TL, SDL, RHL, RLL; TR, SDR, RHR, RLR) associés respectivement à une ligne de transmission de bits (BLL; BLR) sont répartis géométriquement en deux groupes, entre lesquels est située la capacité externe (CEX).